# EUROPEAN PATENT APPLICATION

(11) **EP 4 017 228 A1**
(43) Date of publication of application: **22.06.2022**
(21) Application number: 21213979.4
(22) Date of filing: 13.12.2021
(51) Int. Cl.: H05K 3/42, H05K 3/46

(54) **ELECTRONIC DEVICE AND MANUFACTURING METHOD THEREOF**

(30) Priority: 18.12.2020 US 202063127168 P; 22.10.2021 CN 202111237369
(71) Applicant: InnoLux Corporation, Chu-Nan, Miao-Li County 35053 (TW)
(72) Inventor: CHI, Jen-Hai, Chu-Nan, Miao-Li County 35053 (TW)
(74) Representative: Becker, Eberhard

(57) **Abstract**

An electronic device (1, 1') and a manufacturing method thereof are provided. The manufacturing method of the electronic device (1, 1') includes the following steps. A first carrier (C1) is provided. A first substrate (SUB1) is disposed on the first carrier (C1). A first conductive structure (CS1) is disposed on the first substrate (SUB1), and the first carrier (C1) is removed. A second carrier (C2) is provided. A second substrate (SUB2) is disposed on the second carrier (C2). A second conductive structure (CS2) is disposed on the second substrate (SUB2), and the second carrier (C2) is removed. The first substrate (SUB1) and the second substrate (SUB2) are combined.

## Description

### BACKGROUND

### Technical Field

The disclosure relates to an electronic device and a manufacturing method thereof, and more particularly to an electronic device with two substrates combined and a manufacturing method thereof.

### Description of Related Art

In some electronic devices, two conductive layers are required to be separated by an appropriate distance to meet specific application requirements. If the two conductive layers are formed on the same substrate, and the distance between the two conductive layers is kept by, for example, a dielectric layer, a problem of substrate warpage may occur when the dielectric layer is too thick. Therefore, a process method that can not only separate two conductive layers by an appropriate distance but also better handle the problem of substrate warpage is required.

### SUMMARY

According to an embodiment of the disclosure, a manufacturing method of an electronic device includes the following steps. A first carrier is provided. A first substrate is disposed on the first carrier. A first conductive structure is disposed on the first substrate, and the first carrier is removed. A second carrier is provided. A second substrate is disposed on the second carrier. A second conductive structure is disposed on the second substrate, and the second carrier is removed. The first substrate and the second substrate are combined.

According to an embodiment of the disclosure, an electronic device includes a first substrate, a second substrate, a first conductive structure, and a second conductive structure. The first substrate has a first surface and a second surface opposite to the first surface. The second substrate has a third surface facing the second surface and a fourth surface opposite to the third surface. The first conductive structure is disposed on the first surface. The second conductive structure is disposed on the fourth surface. The second surface is attached to the third surface.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1A to FIG. 1I are schematic partial cross-sectional diagrams of a manufacturing process of an electronic device according to some embodiments of the disclosure.
FIG. 2 is a schematic partial cross-sectional diagram of an electronic device according to some embodiments of the disclosure.
FIG. 3 is a schematic top diagram of an electronic device according to some embodiments of the disclosure.

### DESCRIPTION OF THE EMBODIMENTS

References of the exemplary embodiments of the disclosure are to be made in detail. Examples of the exemplary embodiments are illustrated in the drawings. If applicable, the same reference numerals in the drawings and the descriptions indicate the same or similar parts.

Certain words are used to refer to specific elements throughout the specification and the appended claims of the disclosure. People skilled in the art should understand that electronic device manufacturers may refer to the same elements under different names. The disclosure does not intend to distinguish between elements having same functions but different names. In the following specification and claims, the words "having" and "including" are open-ended words and thus should be interpreted as "including but not limited to."

Wordings used herein to indicate directions, such as "up," "down," "front," "back," "left," and "right," merely refer to directions in the accompanying drawings. Therefore, the directional wordings are used to explain rather than limit the disclosure. In the accompanying drawings, the drawings illustrate the general features of the methods, structures, and/or materials used in specific embodiments. However, the drawings shall not be interpreted as defining or limiting the scope or nature covered by these embodiments. For example, the relative size, thickness, and location of layers, regions, or structures may be reduced or enlarged for clarity.

The description that one structure (or layer, element, substrate) is located on another structure (or layer, element, substrate) described in this disclosure may mean that the two structures are adjacent and directly connected, or may mean that the two structures are adjacent but not directly connected. Indirect connection means that there is at least one intermediate structure (or intermediate layer, intermediate element, intermediate substrate, intermediate space) between the two structures, and the lower surface of one structure is adjacent or directly connected to the upper surface of the intermediate structure while the upper surface of the other structure is adjacent or directly connected to the lower surface of the intermediate structure. The intermediate structure may be composed of a monolayer or multilayer physical structure or a nonphysical structure and is not particularly limited. In this disclosure, when a certain structure is "on" another structure, it may mean that the certain structure is "directly" on another structure, or that the certain structure is "indirectly" on another structure; that is, there is at least one structure between the certain structure and the other structure.

The terms "approximately," "equal to," "equivalent to," "same," "substantially," or "roughly" referred to herein generally mean within 20% of a given value or range, or mean within 10%, 5%, 3%, 2%, 1%, or 0.5% of a given value or range.

Ordinal numbers in this specification and the claims such as "first" and "second" are used to modify a component, and these ordinal numbers do not imply or represent that the component(s) has (or have) any ordinal number nor indicate any order between a component and another component or an order in a manufacturing method. These ordinal numbers are merely used to clearly distinguish a component having a name from another component having the same name. Different terms may be used in the claims and the specification, so that a first member in the specification may be a second member in the claims.

The electrical connections or couplings described in the disclosure may all refer to direct connections or indirect connections. In the case of the direct connection, terminals of elements on two circuits are directly connected or connected through a conductive line, and in the case of the indirect connection, between the terminals of the elements on the two circuits are a switch, a diode, a capacitor, an inductor, a resistor, other suitable elements, or a combination of the above elements, but the disclosure is not limited thereto.

In the disclosure, thickness, length, and width may be measured with an optical microscope, and thickness or width may be measured with a cross-sectional image in an electron microscope, but the disclosure is not limited thereto. Any two values or directions used for comparison may have a certain error. In addition, the terms "approximately," "equal to," "equivalent to," "substantially," or "roughly" referred to herein generally mean within 10% of a given value or range. Moreover, the phrases "in a given range from a first value to a second value" and "within a given range from a first value to a second value" indicate the given range includes the first value, the second value, and other values therebetween. If a first direction is perpendicular to a second direction, the angle between the first direction and the second direction may be between 80 degrees and 100 degrees; if the first direction is parallel to the second direction, the angle between the first direction and the second direction may be between 0 degrees and 10 degrees.

It should be understood that the following embodiments may replace, reorganize, and mix the features in several different embodiments to complete other embodiments without departing from the spirit of the disclosure. As long as the features of the embodiments do not violate the spirit of the disclosure or conflict each other, they may be mixed and matched as desired.

Unless otherwise defined, all terms (including technical terms and scientific terms) used herein have the same meanings commonly understood by people with ordinary knowledge in the technical field to which the present invention belongs. It is further understood that terms such as those defined in commonly used dictionaries should be interpreted as having meanings consistent with their meanings in the context of related technologies and this disclosure, and shall not be interpreted in an idealized or excessively formal way, unless explicitly defined as such in the disclosure.

In the disclosure, an electronic device may include a display device, a backlight device, an antenna device, a sensing device, or a splicing device, but the disclosure is not limited thereto. The electronic device may be a bendable electronic device or a flexible electronic device. The display device may be a non-self-luminous display device or a self-luminous display device. The antenna device may be a liquid crystal antenna device or a non-liquid crystal antenna device, and the sensing device may sense capacitance, light, thermal energy or ultrasonic, but the disclosure is not limited thereto. In the disclosure, an electronic component may include passive components and active components such as capacitors, resistors, inductors, diodes, transistors, IC chips, etc. The diodes may include light emitting diodes or photoelectric diodes. The light emitting diodes may include, for example but not limited to, organic light emitting diodes (OLED), sub-millimeter light emitting diodes (mini LED), micro light emitting diodes (micro LED), or quantum dot light emitting diodes (quantum dot LED). The splicing device may be, for example but not limited to, a display splicing device or an antenna splicing device. It should be noted that the electronic device may be any combination of the foregoing, but the disclosure is not limited thereto. Hereinafter, the display device is used as the electronic device or the splicing device to describe the disclosure, but the disclosure is not limited thereto.

It should be noted that the technical features in different embodiments provided hereinafter may be replaced, combined, or mixed with one another to constitute another embodiment without departing from the spirit of the disclosure.

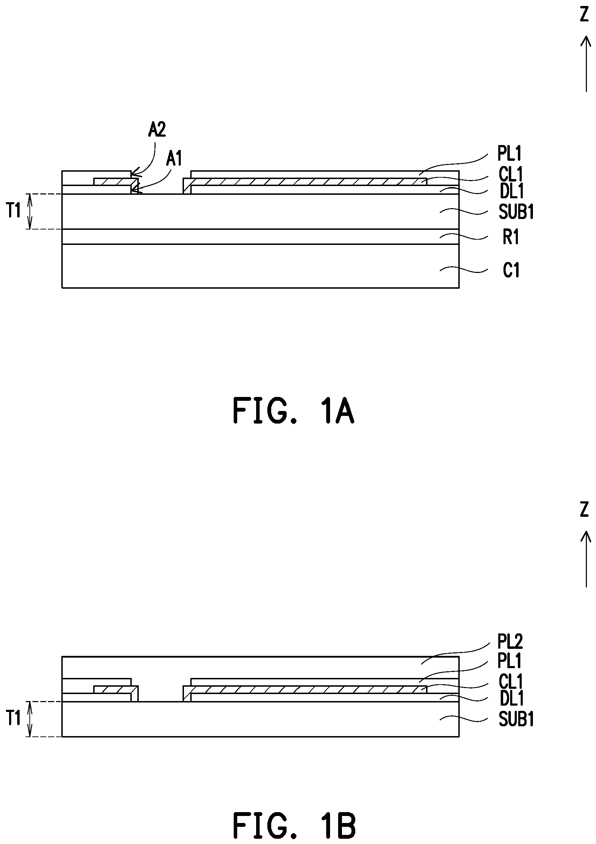

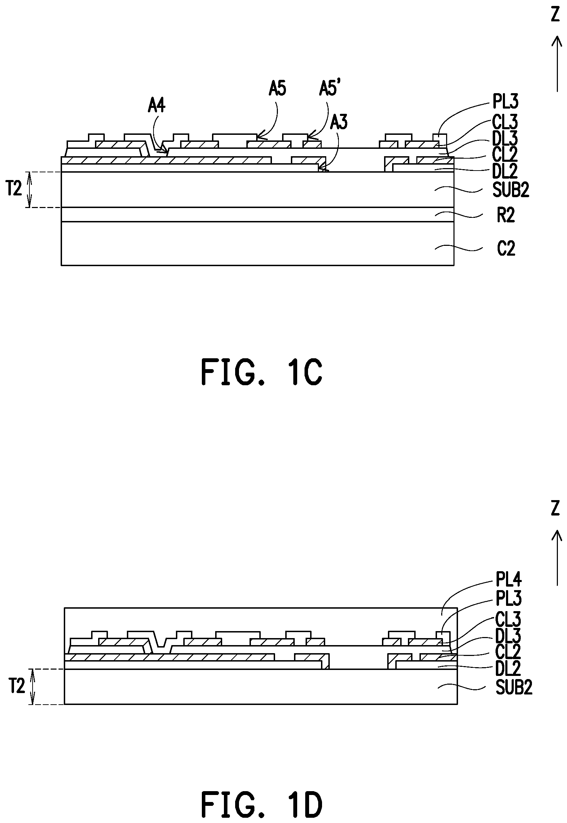

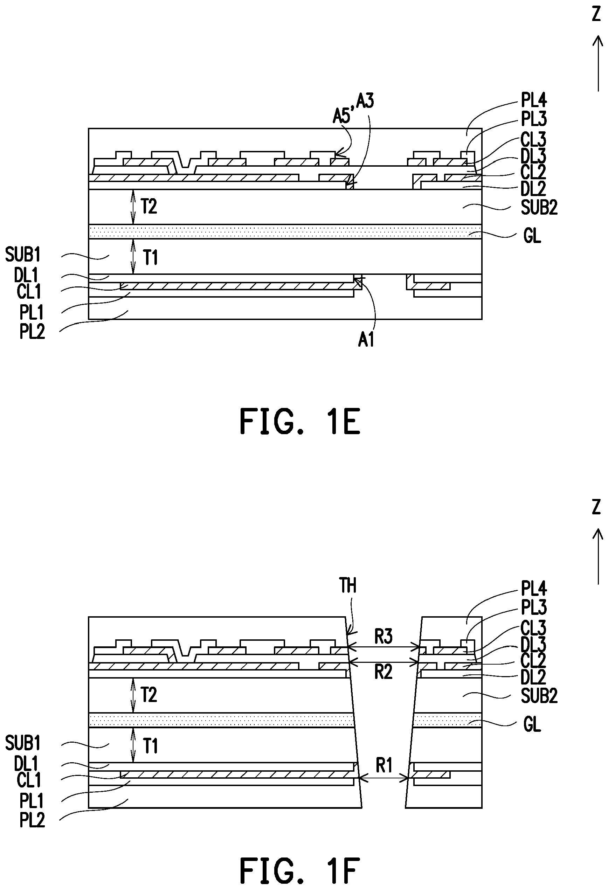

FIG. 1A to FIG. 1I are schematic partial cross-sectional diagrams of a manufacturing process of an electronic device according to some embodiments of the disclosure. With reference to FIG. 1A, the manufacturing process of the electronic device may include providing a first carrier C1 and disposing a release layer R1 and a first substrate SUB1 on the first carrier C1, but the disclosure is not limited thereto. In other words, the release layer R1 may be disposed on the first carrier C1 and located between the first carrier C1 and the first substrate SUB1. In other embodiments, other layers may further be disposed between the release layer R1 and the first substrate SUB 1 as required. In some embodiments, the first carrier C1 may have a material with support properties. A rigid carrier may include a quartz substrate, a glass substrate, a ceramic substrate, a sapphire substrate, a rigid-flex hybrid board, other rigid substrates, or a combination of the above, but the disclosure is not limited thereto. In some embodiments, the release layer R1 may be used to temporarily fix the first substrate SUB1 on the first carrier C1. In some embodiments, the release layer R1 may include a laser release layer or other types of release layers, but the disclosure is not limited thereto. In some embodiments, the release layer R1 may be released, for example but not limited to, through physical or chemical means.

The first substrate SUB 1 may be disposed on the release layer R1. The first substrate SUB1 may include a flexible substrate, a bendable substrate, a rigid substrate, or a combination of the above substrates, but the disclosure is not limited thereto. For example, the material of the first substrate SUB1 may include a polymer, other suitable materials, or a combination of the above, but the disclosure is not limited thereto. For example, the material of the first substrate SUB1 may include polyethylene terephthalate (PET), polyimide (PI), liquid crystal polymer (LCP), cyclo olefin polymer (COP), epoxy resin, Ajinomoto Build-up Film (ABF), bismaleimide, fluororesin, and/or other suitable materials or a combination of the above, but the disclosure is not limited thereto. In some embodiments, the first substrate SUB 1 may include, for example but not limited to, glass, ceramic, quartz, sapphire, or a combination of the above materials. In some embodiments, the material of the first substrate SUB1 may have a low dielectric loss (Df) property, but the disclosure is not limited thereto.

In some embodiments, a thickness T1 of the first substrate SUB1 may be greater than or equal to 5 µm and less than or equal to 1000 µm (5 µm ≦ thickness T1 ≦ 1000 µm), but the disclosure is not limited thereto. In some embodiments, the thickness T1 of the first substrate SUB1 may be greater than or equal to 50 µm and less than or equal to 900 µm (50 µm ≦ thickness T1 ≦ 900 µm). In some embodiments, the thickness T1 of the first substrate SUB1 may be greater than or equal to 150 µm and less than or equal to 800 µm (150 µm ≦ thickness T1 ≦ 800 µm). In some embodiments, the first substrate SUB1 may include a monolayer material or a composite layer material. The above thickness T1 of the first substrate SUB1 may be different depending on the selected material or the number of layers.

The manufacturing process of the electronic device may include disposing a first conductive structure CS1 on the first substrate SUB1. In detail, in some embodiments, a conductive layer CL1 may be disposed on the first substrate SUB1, and a dielectric layer DL1 may be selectively disposed between the first substrate SUB1 and the conductive layer CL1. In some embodiments, the material of the dielectric layer DL1 may include silicon nitride (SiNx), silicon oxide (SiOx), other suitable materials, or a combination of the above, but the disclosure is not limited thereto. As described above, the dielectric layer DL1 may be disposed between the first substrate SUB1 and the conductive layer CL1, such that the yield rate of the conductive layer CL1 being attached to the first substrate SUB1 may be improved to reduce the chance of the first substrate SUB1 being peeled. In addition, the dielectric layer DL1 may reduce the chance of the first substrate SUB1 being invaded by water vapor. In other words, the dielectric layer DL1 may be directly disposed on the first substrate SUB1. In other embodiments (not illustrated), the conductive layer CL1 may be directly disposed on the first substrate SUB 1, but the disclosure is not limited thereto. In other words, there is no other layer between the conductive layer CL1 and the first substrate SUB1. In some embodiments, a protection layer PL1 may be disposed on the first substrate SUB1, and the protection layer PL1 may be disposed on the conductive layer CL1, but the disclosure is not limited thereto. In some embodiments, between the above stacked layers, other layers may further be disposed or any among the layers may be deleted as required.

In some embodiments, when the dielectric layer DL1 is disposed between the first substrate SUB1 and the conductive layer CL1, the dielectric layer DL1 may be a patterned dielectric layer. For example, the dielectric layer DL1 may include an opening A1 exposing part of the first substrate SUB1.

In some embodiments, the conductive layer CL1 may be disposed between the dielectric layer DL1 and the protection layer PL1, and the conductive layer CL1 may be a patterned conductive layer. For example, the conductive layer CL1 may partially cover the dielectric layer DL1 and extend into the opening A1 to cover the side wall of the dielectric layer DL1 exposed by the opening A1. In some embodiments, the conductive layer CL1 may contact part of the first substrate SUB1 through the opening A1. In some embodiments, the conductive layer CL1 may include a monolayer conductive layer or a multilayer conductive layer. In some embodiments, the material of the conductive layer CL1 may include metals such as titanium (Ti), copper (Cu), aluminum (Al), molybdenum (Mo), other suitable materials, or a combination of the above, but the disclosure is not limited thereto.

Through the above manufacturing process, the first conductive structure CS1 is disposed on the first substrate SUB1. In some embodiments, the first conductive structure CS1 may include at least one conductive layer (such as the conductive layer CL1) and at least one dielectric layer (such as the dielectric layer DL1), but the disclosure is not limited thereto.

In some embodiments, the protection layer PL1 may be disposed on the first conductive structure CS1 (including the dielectric layer DL1 and/or the conductive layer CL1), but the disclosure is not limited thereto. The protection layer PL1 may be a patterned protection layer. For example, the protection layer PL1 may include an opening A2 exposing part of the first substrate SUB1. In some embodiments, in the normal direction (such as a direction Z) of the first substrate SUB1, the opening A2 of the protection layer PL1 may overlap the opening A1 of the dielectric layer DL1. In some embodiments, in the normal direction (such as the direction Z) of the first substrate SUB1, the orthographic projection area (not marked) of the opening A2 of the protection layer PL1 on the first substrate SUB1 may be greater than or equal to the orthographic projection area (not marked) of the opening A1 of the dielectric layer DL1 on the first substrate SUB1, but the disclosure is not limited thereto.

In some embodiments, the opening A2 of the protection layer PL1 may expose part of the conductive layer CL1. For example, the conductive layer CL1 extending into the opening A1 may be exposed. In some embodiments, the material of the protection layer PL1 may include silicon nitride (SiNx), silicon oxide (SiOx), other suitable materials, or a combination of the above, but the disclosure is not limited thereto. The protection layer PL1 may reduce the chance of the conductive layer CL1 being invaded by water vapor.

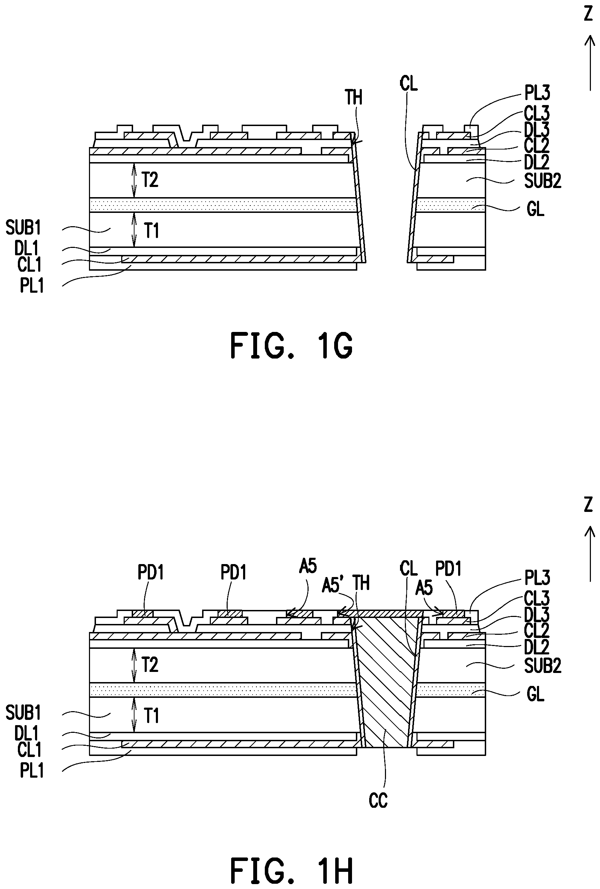

With reference to FIG. 1B, the manufacturing process of the electronic device may further include disposing a protection layer PL2 on the protection layer PL1, but the disclosure is not limited thereto. In some embodiments, the protection layer PL2 may be used as a temporary protective film (TPF). In some embodiments, the protection layer PL2 may be removed in the subsequent manufacturing process of the electronic device (reference may be made to FIG. 1G), but the disclosure is not limited thereto. In some embodiments, the protection layer PL2 may include a monolayer material or a composite material. When the protection layer PL2 is a composite material, it may include a combination of a film layer, a glue layer, and/or other suitable materials, but the disclosure is not limited thereto. The film layer includes, for example but not limited to, PET, PI, other suitable materials, and/or a combination of the above. The glue includes, for example but not limited to, a pressure sensitive glue, an acrylic glue, epoxy, silicon, other suitable materials, and/or a combination of the above.

With reference to FIG. 1B, in some embodiments, the manufacturing process of the electronic device may further include removing the first carrier C1. For example, after the protection layer PL2 is formed, a release step may be performed on the release layer R1 to separate the first carrier C1 and the first substrate SUB1. In some embodiments, the protection layer PL2 may have support properties, which may be used to support the first substrate SUB 1 after the first carrier C1 is removed, but the disclosure is not limited thereto.

With reference to FIG. 1C, the manufacturing process of the electronic device may further include providing a second carrier C2 and disposing a release layer R2 and a second substrate SUB2 on the second carrier C2. In other embodiments, other layers may further be disposed between the release layer R2 and the second substrate SUB2 as required. In some embodiments, the second carrier C2 may have a material with support properties. The second carrier C2 may include a quartz substrate, a glass substrate, a ceramic substrate, a sapphire substrate, a rigid-flex hybrid board, other rigid substrates, or a combination of the above, but the disclosure is not limited thereto. In some embodiments, the release layer R2 may be used to temporarily fix the second substrate SUB2 on the second carrier C2. In some embodiments, the release layer R2 may include a laser release layer or other types of release layers, but the disclosure is not limited thereto. In some embodiments, the release layer R2 may be released, for example but not limited to, through physical or chemical means.

With reference to FIG. 1C, the second substrate SUB1 may be disposed on the release layer R2. The second substrate SUB2 may include a flexible substrate, a bendable substrate, a rigid substrate, or a combination of the above substrates, but the disclosure is not limited thereto. For example, the material of the second substrate SUB2 may be a polymer, other suitable materials, or a combination of the above, but the disclosure is not limited thereto. For example, the material of the second substrate SUB2 may include PET, PI, LCP, COP, epoxy resin, ABF, bismaleimide, fluororesin and/or other suitable materials or a combination of the above, but the disclosure is not limited thereto. In some embodiments, the material of the second substrate SUB2 may include, for example but not limited to, glass, ceramic, quartz, sapphire, or a combination of the above materials. In some embodiments, the material of the first substrate SUB1 may have a low dielectric loss (Df) property, but the disclosure is not limited thereto. In some embodiments, a thickness T2 of the second substrate SUB2 may be greater than or equal to 5 µm and less than or equal to 1000 µm (5 µm ≦ thickness T2 ≦ 1000 µm), but the disclosure is not limited thereto. In some embodiments, the thickness T2 of the second substrate SUB2 may be greater than or equal to 50 µm and less than or equal to 900 µm (50 µm ≦ thickness T2 ≦ 900 µm). In some embodiments, the thickness T2 of the second substrate SUB2 may be greater than or equal to 150 µm and less than or equal to 800 µm (150 µm ≦ thickness T2 ≦ 800 µm). In some embodiments, the second substrate SUB2 may include a monolayer material or a composite layer material. The above thickness T2 of the second substrate SUB2 may be different depending on the selected material or the number of layers.

In some embodiments, the sum of the thickness T1 of the first substrate SUB1 and the thickness T2 of the second substrate SUB2 may be greater than or equal to 10 µm and less than or equal to 2000 µm (10 µm ≦ T1+T2 ≦ 2000 µm), but the disclosure is not limited thereto. In some embodiments, the sum of the thickness T1 of the first substrate SUB1 and the thickness T2 of the second substrate SUB2 may be greater than or equal to 100 µm and less than or equal to 1700 µm (100 µm ≦ T1+T2 ≦ 1700 µm). In some embodiments, the sum of the thickness T1 of the first substrate SUB1 and the thickness T2 of the second substrate SUB2 may be greater than or equal to 200 µm and less than or equal to 1500 µm (200 µm ≦ T1+T2 ≦ 1500 µm). In some embodiments, when the electronic device is applied to an antenna, the sum of the thickness T1 of the first substrate SUB1 and the thickness T2 of the second substrate SUB2 may be designed according to a frequency applied by the electronic device; for example, the frequency and "the sum of the thickness T1 and the thickness T2" may roughly be inversely proportional, but the disclosure is not limited thereto.

In some embodiments, the material of at least one of the first substrate SUB1 and the second substrate SUB2 is a polymer. In some embodiments, the first substrate SUB1 and the second substrate SUB2 are polymers. In some embodiments, the thickness T1 of the first substrate SUB 1 and the thickness T2 of the second substrate SUB may be the same or different. In some embodiments, the area of the first substrate SUB 1 and the area of the second substrate SUB2 are different. In some embodiments, the material of the first substrate SUB1 and the material of the second substrate SUB2, for example, may be the same or different.

With reference to FIG. 1C, the manufacturing process of the electronic device may further include disposing a second conductive structure CS2 on the second substrate SUB2. In detail, in some embodiments, a conductive layer CL2 is disposed on the second substrate SUB2. In some embodiments, a dielectric layer DL2 may be selectively disposed between the second substrate SUB2 and the conductive layer CL2. In some embodiments, the material of the dielectric layer DL2 may include silicon nitride (SiNx), silicon oxide (SiOx), other suitable materials, or a combination of the above, but the disclosure is not limited thereto. As described above, the dielectric layer DL2 is disposed between the second substrate SUB2 and the conductive layer CL2, such that the yield rate of the conductive layer CL2 being attached to the second substrate SUB2 may be improved to reduce the chance of the second substrate SUB2 being peeled. In addition, the dielectric layer DL2 may reduce the chance of the second substrate SUB2 being invaded by water vapor. In other embodiments (not illustrated), the conductive layer CL2 may be directly disposed on the second substrate SUB2, but the disclosure is not limited thereto. In other words, there is no other layer between the conductive layer CL2 and the second substrate SUB2. In some embodiments, a dielectric layer DL3, a conductive layer CL3, and/or a protection layer PL3 may be disposed on the conductive layer CL2, but the disclosure is not limited thereto. Between the above stacked layers, other layers may further be disposed or any among the layers may be deleted as required.

In some embodiments, the dielectric layer DL2 may be disposed on the second substrate SUB2 and located between the second substrate SUB2 and the conductive layer CL2. The dielectric layer DL2 may be a patterned dielectric layer. For example, the dielectric layer DL2 may include an opening A3 exposing the second substrate SUB2. In some embodiments, the material of the dielectric layer DL2 is similar to that of the dielectric layer DL1, so the description is not repeated herein. In some embodiments, the dielectric layer DL2 may be used to reduce the chance of the second substrate SUB2 being invaded by water vapor or to reduce the peeling problem of the second substrate SUB2.

In some embodiments, the conductive layer CL2 may be disposed between the dielectric layer DL2 and the dielectric layer DL3, and the conductive layer CL2 may be a patterned conductive layer. For example, the conductive layer CL2 may partially cover the dielectric layer DL2 and extend into the opening A3 to cover the side wall of the dielectric layer DL2 exposed by the opening A3. In some embodiments, the conductive layer CL2 may contact part of the second substrate SUB2 through the opening A3. In some embodiments, the conductive layer CL2 may be a monolayer conductive layer or a multilayer conductive layer. The material of the conductive layer CL2 may include metals such as titanium (Ti), copper (Cu), aluminum (Al), molybdenum (Mo), other suitable materials, or a combination of the above, but the disclosure is not limited thereto.

In some embodiments, the dielectric layer DL3 may be disposed on the conductive layer CL2 and located between the conductive layer CL2 and the conductive layer CL3. The dielectric layer DL3 may be a patterned dielectric layer. The dielectric layer DL3 may include an opening A4 exposing part of the conductive layer CL2. In some embodiments, in the normal direction of the second substrate SUB2, the opening A4 of the dielectric layer DL3 may, for example, not overlap the opening A3 of the dielectric layer DL2. In some embodiments, the material of the dielectric layer DL3 may include silicon nitride (SiNx), silicon oxide (SiOx), epoxy, acrylic materials, bismaleimide, polyimide, photoresist materials, other suitable materials, or a combination of the above, but the disclosure is not limited thereto. In some embodiments, the dielectric layer DL3 may have solder resist material properties.

In some embodiments, the conductive layer CL3 may be disposed on the dielectric layer DL3 and located between the dielectric layer DL3 and the protection layer PL3. The conductive layer CL3 may be a patterned conductive layer. For example, the conductive layer CL3 may partially cover the dielectric layer DL3. In some embodiments, part of the conductive layer CL3 may extend into the opening A4 and contact part of the conductive layer CL2. In some embodiments, part of the conductive layer CL3 may extend into the opening A4 and contact part of the side wall of the dielectric layer DL3 exposed by the opening A4, but the disclosure is not limited thereto. In some embodiments, the conductive layer CL3 may be a monolayer conductive layer or a multilayer conductive layer. The material of the conductive layer CL3 may be similar to that of the conductive layer CL2, so the description is not repeated herein.

In some embodiments, the protection layer PL3 may be disposed on the dielectric layer DL3 and the conductive layer CL3. The protection layer PL3 may be a patterned protection layer. For example, the protection layer PL3 may have an opening A5 exposing part of the conductive layer CL3 and have an opening A5' exposing part of the conductive layer CL3 and part of the dielectric layer DL3, but the disclosure is not limited thereto. In some embodiments, the material of the protection layer PL3 may include silicon nitride (SiNx), silicon oxide (SiOx), other suitable materials, or a combination of the above, but the disclosure is not limited thereto. In some embodiments, the protection layer PL3 may be used to reduce the chance of being invaded by water vapor.

Through the above manufacturing process, the second conductive structure CS2 is disposed on the second substrate SUB2. In some embodiments, the second conductive structure CS2 may include at least one conductive layer (such as the conductive layer CL2 and/or the conductive layer CL3) and at least one dielectric layer (such as the dielectric layer DL2 and/or the dielectric layer DL3), but the disclosure is not limited thereto.

With reference to FIG. ID, the manufacturing process of the electronic device may further include forming a protection layer PL4 on the protection layer PL3. In some embodiments, the protection layer PL4 may be a temporary protective film, but the disclosure is not limited thereto. In some embodiments, the protection layer PL4 may be removed in the subsequent manufacturing process of the electronic device (reference may be made to FIG. 1G), but the disclosure is not limited thereto. In some embodiments, the material of the protection layer PL4 may be similar to the above protection layer PL2, so the description is not repeated herein.

In some embodiments, the manufacturing process of the electronic device may further include removing the second carrier C2. For example, after the protection layer PL4 is formed, a release step may be performed on the release layer R2 to separate the second carrier C2 and the second substrate SUB2. In some embodiments, the protection layer PL4 may have support properties, which may be used to support the second substrate SUB2 after the second carrier C2 is removed, but the disclosure is not limited thereto.

In some embodiments, the steps shown in FIG. 1C and FIG. ID may be performed after the steps shown in FIG. 1A and FIG. 1B are completed. Alternatively, the steps shown in FIG. 1A and FIG. 1B may be performed after the steps shown in FIG. 1C and FIG. ID are completed. The numbers of conductive layers, dielectric layers, and/or protection layers illustrated in FIG. 1A to FIG. ID are only examples, and the numbers of conductive layers, dielectric layers, and/or protection layers formed on the first substrate SUB 1 or the second substrate SUB2 may be changed as required. In addition, the number of openings and the corresponding disposition relationship of each layer illustrated in FIG. 1A to FIG. ID are only examples and may be adjusted as required.

With reference to FIG. IE, the manufacturing process of the electronic device may include combining the first substrate SUB1 and the second substrate SUB2. For example, in some embodiments, the first substrate SUB1 may be combined (or attached) with the second substrate SUB2 by a glue GL. The glue GL may include an acrylic glue, an epoxy glue, a pressure sensitive glue, an ultraviolet (UV) glue, other suitable materials, or a combination of the above, but the disclosure is not limited thereto. After the first substrate SUB 1 is combined with the second substrate SUB2, in the normal direction (such as the direction Z) of the first substrate SUB1, the opening A1 of the dielectric layer DL1 may substantially overlap the opening A3 of the dielectric layer DL2. In the normal direction (such as the direction Z) of the first substrate SUB 1, the opening A5' of the dielectric layer DL3 may substantially overlap the opening A3 of the dielectric layer DL2 and/or the opening A1 of the dielectric layer DL1.

With reference to FIG. 1F, the manufacturing process of the electronic device may further include performing a through hole process on the first substrate SUB 1 and the second substrate SUB2 that have been bonded (or attached) together to form a through hole TH. The through hole TH may penetrate the first substrate SUB1 and the second substrate SUB2. The through hole process may include forming the through hole TH by laser or other suitable methods, but the disclosure is not limited thereto. In the normal direction (such as the direction Z) of the first substrate SUB1, the position where the through hole TH is formed may overlap the opening A1, the opening A3, and/or the opening A5'. In some embodiments, the through hole TH may expose part of the conductive layers (the conductive layer CL1, the conductive layer CL2, and/or the conductive layer CL3).

In some embodiments, as shown in FIG. IF, the through hole process may be performed, for example, from the side of the second substrate, such that the through hole TH has different widths of the pore size in different cross-sectional views. For example, the cross-sectional shape of the through hole TH may be similar to an inverted trapezoid, but the disclosure is not limited thereto. In detail, a width R3 of the size of the through hole TH corresponding to the conductive layer CL3 may be greater than a width R2 of the size of the through hole TH corresponding to the conductive layer CL2, and the width R2 of the size of the through hole TH corresponding to the conductive layer CL2 may be greater than a width R1 of the size of the through hole TH corresponding to the conductive layer CL1, but the disclosure is not limited thereto. The width R3 of the size and the width R2 of the size may be a width of the pore size measured in a cross-section and corresponding to the surface of each conductive layer furthest away from the second substrate SUB2. In addition, the width R1 of the size may be, for example, a width of the size measured in the same cross-section and corresponding to the surface of the conductive layer CL1 furthest away from the first substrate SUB 1.

In other embodiments (not illustrated), the through hole process may be performed from one side of the first substrate SUB 1, such that the cross-sectional shape of the through hole TH is similar to an upright trapezoid. For example, the width R1 of the size may be greater than the width R2 of the size, and the width R2 of the size may be greater than the width R3 of the size. Alternatively, in other embodiments (not illustrated), the through hole processes may be performed respectively from one side of the second substrate SUB2 and one side of the first substrate SUB1, such that the cross-sectional shape of the through hole TH is similar to an hourglass shape. For example, the width of the pore size of the through hole TH at the surface of the protection layer PL4 far away from the second substrate SUB2 may be greater than the width of the size of the through hole TH at the glue GL, and the width of the size of the through hole TH at the surface of the corresponding protection layer PL2 far away from the first substrate SUB1 may be greater than the width of the size of the through hole TH at the glue GL, but the disclosure is not limited thereto.

In some embodiments, the manufacturing process of the electronic device may further include a modification step of the surface exposed by the through hole TH. For example, the modification step may be performed on the surface of a non-metallic layer (such as the dielectric layer, the protection layer) exposed by the through hole TH. In some embodiments, the modification step may form a colloidal palladium (not illustrated) on the surface of the layer exposed by the through hole TH, such that the conductive material may be attached to the material surface in the subsequent manufacturing process, but the disclosure is not limited thereto.

With reference to FIG. 1G, the manufacturing process of the electronic device may further include a conductive layer CL disposed in the through hole TH, and the first conductive structure CS1 and the second conductive structure CS2 may be electrically connected through the conductive layer CL. The conductive layer CL may be disposed on the surface of the layer exposed by the through hole TH. The conductive layer CL may be electrically connected to circuits exposed by the through hole TH, such as part of circuits in the conductive layer CL1, part of circuits in the conductive layer CL2, and/or part of circuits in the conductive layer CL3 exposed by the through hole TH. The conductive layer CL may include metals, and the metals may include titanium (Ti), copper (Cu), aluminum (Al), molybdenum (Mo), other suitable materials, or a combination of the above, but the disclosure is not limited thereto. In some embodiments, the conductive layer CL may be formed by a method including electroless plating, deposition, or other suitable methods, but the disclosure is not limited thereto.

In some embodiments, the manufacturing process of the electronic device may further include removing the protection layer PL2 and/or the protection layer PL4. In some embodiments, the protection layer PL2 and/or the protection layer PL4 may be removed before the conductive layer CL is formed. In other embodiments, the protection layer PL2 and/or the protection layer PL4 may be removed after the conductive layer CL is formed. In other words, the protection layer PL2 and/or the protection layer PL4 may be removed from the final electronic device.

With reference to FIG. 1H, the manufacturing process of the electronic device may further include forming a conductive material CC in the through hole TH. The conductive material CC may be wrapped around by the conductive layer CL. In some embodiments, the conductive material CC may contact the conductive layer CL and be electrically connected to each other. In some embodiments, the material of the conductive material CC may include conductive polymer materials, metal materials, transparent conductive materials, or a combination of the above. For example, the conductive material CC may include copper paste, silver paste, nano copper, other conductive materials, or a combination of the above.

With reference to FIG. 1H, in some embodiments, the manufacturing process of the electronic device may further include multiple pads PD1. The pads PD1 may be disposed on the second substrate SUB2, and the pads PD1 may be disposed in multiple openings A5 and/or the opening A5 on the protection layer PL3, but the disclosure is not limited thereto. For example, the pads PD1 may be, for example but not limited to, formed of electroless nickel immersion gold (ENIG), and the material of the pads PD1 may be adjusted as required.

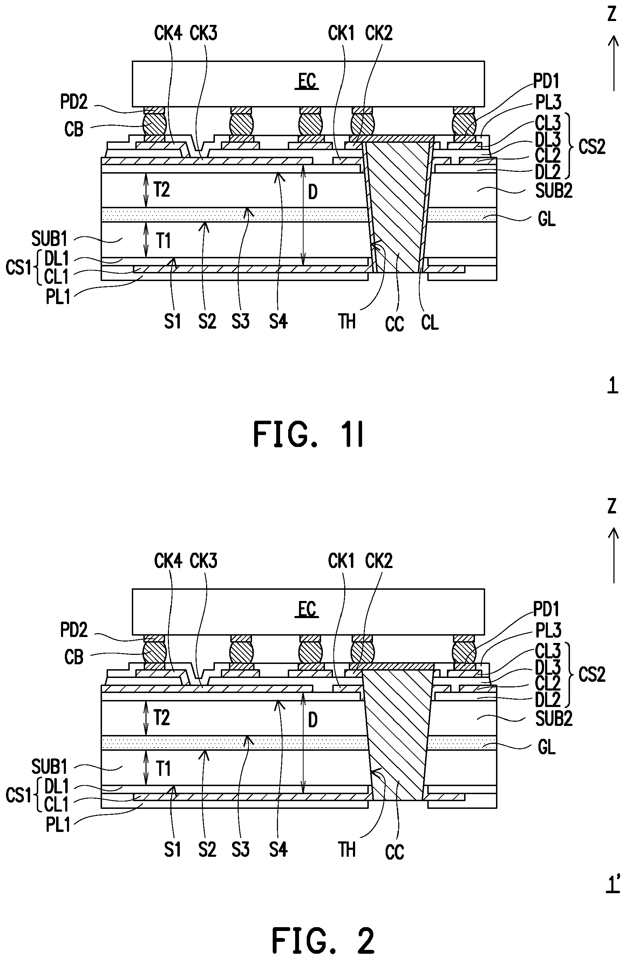

With reference to FIG. 1I, in some embodiments, the manufacturing process of the electronic device may further include bonding an electronic component EC to one of the first substrate SUB1 and the second substrate SUB2. In some embodiments, the electronic component EC may include passive components and active components such as capacitors, resistors, inductors, diodes, transistors, IC chips, etc., but the disclosure is not limited thereto. In some embodiments, multiple pads PD2 of the electronic component EC may be respectively bonded to the pads PD1 on the second substrate SUB2 through multiple conductive components CB, but the disclosure is not limited thereto. In other embodiments (not illustrated), the pads PD1 may be disposed on the first substrate SUB1, and the pads PD2 of the electronic component EC may be, for example, respectively bonded to the pads PD1 on the first substrate SUB1 through the conductive components CB, but the disclosure is not limited thereto.

After the above bonding step, an electronic device 1 is preliminarily manufactured. The electronic device 1 may include the first substrate SUB1, the second substrate SUB2, the first conductive structure CS1, and/or the second conductive structure CS2. The first substrate SUB1 has a first surface S1 and a second surface S2 opposite to the first surface S1. The second substrate SUB2 has a third surface S3 facing the second surface S2 and a fourth surface S4 opposite to the third surface S3. The first conductive structure CS1 is disposed on the first surface S1. The second conductive structure CS2 is disposed on the fourth surface S4. The second surface S2 is attached to the third surface S3, and the thickness of the first substrate SUB1 and the thickness of the second substrate SUB2 are greater than or equal to 5 µm and less than or equal to 1000 µm. For example, the second surface S2 may be attached to the third surface S3 through the glue GL, but the disclosure is not limited thereto.

In some embodiments, the electronic device 1 may further include the through hole TH, the conductive layer CL, and/or the electronic component EC. The through hole TH may penetrate the first substrate SUB1 and the second substrate SUB2. The conductive layer CL may be disposed in the through hole TH, and the first conductive structure CS1 and the second conductive structure CS2 may be electrically connected through the conductive layer CL. In some embodiments, the first conductive structure CS1 may include at least one conductive layer (such as the conductive layer CL1) and at least one dielectric layer (such as the dielectric layer DL1), and one of the at least one dielectric layer (such as the dielectric layer DL1) may be directly disposed on the first substrate SUB1, but the disclosure is not limited thereto. In some embodiments, the second conductive structure CS2 may include at least one conductive layer (such as the conductive layer CL2 and/or the conductive layer CL3) and at least one dielectric layer (such as the dielectric layer DL2 and/or the dielectric layer DL3), and one of the at least one dielectric layer (such as the dielectric layer DL2) may be directly disposed on the second substrate SUB2, but the disclosure is not limited thereto. In other embodiments (not illustrated), the first conductive structure CS1 may be a conductive layer (such as the conductive layer CL1), and the conductive layer may be directly disposed on the first substrate SUB1. In other embodiments (not illustrated), the second conductive structure CS2 may be a conductive layer (such as the conductive layer CL2), and the conductive layer may be directly disposed on the second substrate SUB2.

In some embodiments, as shown in FIG. 1I, part of circuits in the conductive layer CL1 and the conductive layer CL2 (such as a circuit CK1) and part of circuits in the conductive layer CL3 (such as a circuit CK2) may be electrically connected through the conductive layer CL. For example, taking the electronic device 1 as an antenna device for example, part of circuits in the conductive layer CL1 and the conductive layer CL2 (such as the circuit CK1) and part of circuits in the conductive layer CL3 (such as the circuit CK2) may be electrically connected to a first signal of the electronic component EC through the corresponding pads PD1 and/or conductive components CB. The first signal is, for example but not limited to, a radio frequency signal. On the other hand, as shown in FIG. 1I, part of circuits in the conductive layer CL2 (such as a circuit CK3) and part of circuits in the conductive layer CL3 (such as a circuit CK4) may be electrically connected to a second signal through the corresponding pads PD1 and/or conductive components CB. The second signal is, for example but not limited to, a ground signal. In some embodiments, the first signal and the second signal have a voltage potential difference.

In some embodiments, a distance Dis between the conductive layer closest to the first substrate SUB1 (such as the conductive layer CL1) in the first conductive structure CS1 and the conductive layer closest to the second substrate SUB2 (such as the conductive layer CL2) in the second conductive structure CS2. In some embodiments, when the electronic device is applied to an antenna, the distance D may be designed differently according to the frequency or other parameters (such as the impedance of the above two conductive layers) applied by the electronic device, and the frequency and "the distance D" may roughly be inversely proportional, but the disclosure is not limited thereto. In some embodiments, as shown in FIG. 1I, the distance D between the above two conductive layers may be separated by an insulating layer and/or a dielectric layer disposed between the two conductive layers. For example, as shown in FIG. 1I, the distance D may be separated by substrates (such as the first substrate SUB1 and/or the second substrate SUB2), dielectric layers (such as the dielectric layer DL1, the dielectric layer DL2 and/or the dielectric layer DL3), protection layers (such as the protection layer PL1 and/or the protection layer PL3), and/or a glue (such as the glue GL), etc., and the value of the distance D may be obtained from the sum of the thicknesses of these layers in the direction Z. The distance D may be adjusted with the insulating layer and/or the dielectric layer disposed between the two conductive layers. In some embodiments, the distance D may be, for example but not limited to, greater than or equal to 10 µm and less than or equal to 2000 µm (10 µm ≦ distance D ≦ 2000 µm), but the disclosure is not limited thereto. In some embodiments, the distance D may be, for example but not limited to, greater than or equal to 100 µm and less than or equal to 1800 µm (100 µm ≦ distance D ≦ 1800 µm), but the disclosure is not limited thereto. In some embodiments, the distance D may be, for example but not limited to, greater than or equal to 200 µm and less than or equal to 1500 µm (200 µm ≦ distance D ≦ 1500 µm), but the disclosure is not limited thereto.

In some embodiments, the electronic device 1 may serve as a circuit board, and the first conductive structure CS1 and/or the second conductive structure CS2 may be redistribution layers (RDL), but the disclosure is not limited thereto.

In some embodiments, the warpage problem may be reduced by respectively forming different conductive layers on two substrates. In addition, compared to forming different conductive layers on two opposite sides of one substrate through a double-sided process, this embodiment forms conductive layers on single sides of different substrates, which may reduce the difficulty of the process.

FIG. 2 is a schematic partial cross-sectional diagram of an electronic device according to some embodiments of the disclosure. With reference to FIG. 2, the main differences between an electronic device 1' and the electronic device 1 of FIG. 1I are explained as follows. The electronic device 1' may not include the conductive layer CL of FIG. 1I, and the conductive material CC may be electrically connected to a film layer (such as the conductive layer CL1) or circuits (such as the circuit CK1 and the circuit CK2) exposed by the through hole TH. For example, after the through hole process (as shown in FIG. IF), the conductive material CC may be formed in the through hole TH. The material of the conductive material CC may be as described above.

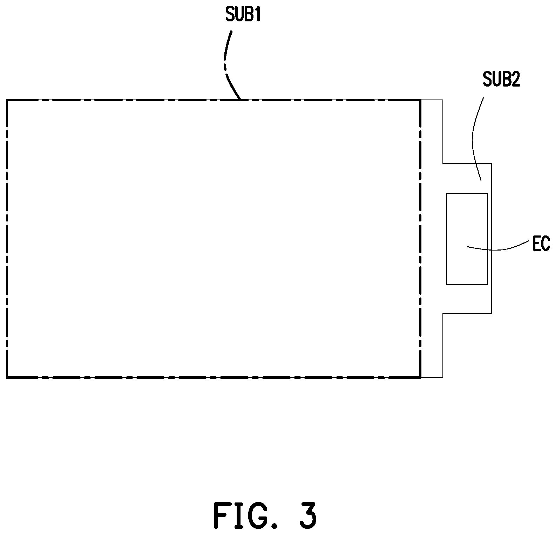

FIG. 3 is a schematic top diagram of an electronic device according to some embodiments of the disclosure.

In some embodiments, when the electronic device is viewed from a top view perspective, the area of the first substrate SUB1 and the area of the second substrate SUB2 are different. For example, the area of the second substrate SUB2 may be greater than the area of the first substrate SUB 1, but the disclosure is not limited thereto. In some embodiments, the electronic component EC may be bonded to one of the first substrate SUB 1 and the second substrate SUB2, and the electronic component EC may be bonded to the second substrate SUB2 having a greater area, but the disclosure is not limited thereto. In other embodiments (not illustrated), the area of the first substrate SUB1 may be greater than the area of the second substrate SUB2.

In other embodiments (not illustrated), when the electronic device is viewed from a top view perspective, the appearance of the first substrate SUB1 and the appearance of the second substrate SUB2 may be the same or different. In other embodiments (not illustrated), when the electronic device is viewed from a top view perspective, the area or appearance of the first substrate SUB1 and that of the second substrate SUB2 are similar. However, when the first substrate SUB1 and the second substrate SUB2 are combined a slight shift may cause part of the first substrate SUB 1 not to overlap the second substrate SUB2, but the disclosure is not limited thereto.

It should be noted that although not illustrated, other substrates or polymers may be disposed between the first substrate SUB1 and the second substrate SUB2 as required. In addition, when other substrates or polymers are disposed between the first substrate SUB1 and the second substrate SUB2, the other substrates (or polymers) may be selectively attached to the first substrate SUB1 and/or the second substrate SUB2 through other glues (not illustrated).

In summary, in the embodiment of the disclosure, forming different conductive layers on two substrates and maintaining the distance between different conductive layers with two substrates help reduce the process cost and time or better handle the problem of substrate warpage. In addition, the use of a single-sided process may reduce the difficulty of the process. In some embodiments, the use of polymer substrates as the first substrate and the second substrate may facilitate the through hole process or reduce the probability of chipping or cracking of the substrate during the through hole process. In some embodiments, the electronic device may include a through hole penetrating the first substrate and the second substrate, and a conductive material may be formed in the through hole. By appropriately selecting the conductive material, heat dissipation or heat conduction effect may be further improved.

Although the disclosure has been disclosed in the above embodiments, the embodiments are not intended to limit the disclosure. People skilled in the art may make some changes, replacements, and modifications without departing from the spirit and the scope of the disclosure, and the features between the embodiments may be arbitrarily mixed and matched to form other new embodiments. Moreover, the scope of the disclosure is limited to the processes, machines, manufacture, compositions of matter, means, methods, or steps of the particular embodiments described in the specification. People of ordinary skill in the art may understand the processes, machines, manufacture, compositions of matter, means, methods, or steps, presently existing or later to be developed from the disclosure. Those performing substantially the same function or achieving substantially the same result as the corresponding embodiments described herein may be utilized according to the disclosure. Therefore, the appended claims of the disclosure include the above processes, machines, manufacture, compositions of matter, means, methods, or steps. In addition, each claim constitutes a separate embodiment, and the scope of the disclosure also includes a combination of each claim and embodiment. The scope of the disclosure is subject to the definition of the scope of the appended claims.

## Claims

1. A manufacturing method of an electronic device (1, 1'), comprising:
providing a first carrier (C1);
disposing a first substrate (SUB1) on the first carrier (C1);
disposing a first conductive structure (CS1) on the first substrate (SUB1);
removing the first carrier (C1);
providing a second carrier (C2);
disposing a second substrate (SUB2) on the second carrier (C2);
disposing a second conductive structure (CS2) on the second substrate (SUB2);
removing the second carrier (C2); and
combining the first substrate (SUB1) and the second substrate (SUB2).

2. The manufacturing method of the electronic device (1, 1') according to claim 1, wherein the first substrate (SUB1) is combined with the second substrate (SUB2) by a glue (GL).

3. The manufacturing method of the electronic device (1, 1') according to claim 1 or 2, further comprising:
forming a through hole (TH), the through hole (TH) penetrating the first substrate (SUB 1) and the second substrate (SUB2).

4. The manufacturing method of the electronic device (1) according to claim 3, further comprising:
disposing a conductive layer (CL) in the through hole (TH), wherein the first conductive structure (CS1) and the second conductive structure (CS2) are electrically connected through the conductive layer (CL).

5. The manufacturing method of the electronic device (1, 1') according to any of claims 1 to 4, wherein a thickness (T1) of the first substrate (SUB1) and a thickness (T2) of the second substrate (SUB2) are greater than or equal to 5 µm and less than or equal to 1000 µm.

6. The manufacturing method of the electronic device (1, 1') according to any of claims 1 to 5, wherein material of at least one of the first substrate (SUB1) and the second substrate (SUB2) is a polymer.

7. The manufacturing method of the electronic device (1, 1') according to any of claims 1 to 5, wherein material of the first substrate (SUB1) and material of the second substrate (SUB2) are both polymers.

8. The manufacturing method of the electronic device (1, 1') according to any of claims 1 to 7, wherein an area of the first substrate (SUB1) and an area of the second substrate (SUB2) are different.

9. The manufacturing method of the electronic device (1, 1') according to any of claims 1 to 8, wherein a thickness (T1) of the first substrate (SUB1) and a thickness (T2) of the second substrate (SUB2) are different.

10. The manufacturing method of the electronic device (1, 1') according to any of claims 1 to 9, further comprising:
bonding an electronic component (EC) to one of the first substrate (SUB 1) and the second substrate (SUB2).

11. An electronic device (1, 1'), comprising:
a first substrate (SUB1), having a first surface (S1) and a second surface (S2) opposite to the first surface (S1);
a second substrate (SUB2), having a third surface (S3) facing the second surface (S2) and a fourth surface (S4) opposite to the third surface (S3);
a first conductive structure (CS1), disposed on the first surface (S1); and
a second conductive structure (CS2), disposed on the fourth surface (S4);
wherein the second surface (S2) is attached to the third surface (S3).

12. The electronic device according to claim 11, wherein the first substrate (SUB1) is combined with the second substrate (SUB2) by a glue (GL).

13. The electronic device (1, 1') according to claim 11 or 12, further comprising:
a through hole (TH), penetrating the first substrate (SUB1) and the second substrate (SUB2).

14. The electronic device (1) according to claim 13, further comprising:
a conductive layer (CL), disposed in the through hole (TH), wherein the first conductive structure (CS1) and the second conductive structure (CS2) are electrically connected through the conductive layer (CL).

15. The electronic device (1, 1') according to any of claims 11 to 14, wherein a thickness (T1) of the first substrate (SUB1) and a thickness (T2) of the second substrate (SUB2) are greater than or equal to 5 µm and less than or equal to 1000 µm.
